# EUROPEAN PATENT APPLICATION

(11) **EP 2 287 923 A1**
(43) Date of publication of application: **23.02.2011**
(21) Application number: 10157021.6
(22) Date of filing: 19.03.2010
(51) Int. Cl.: H01L 33/00, H01L 33/38, H01L 33/14

(54) **Light emitting device and method for manufacturing same**

(30) Priority: 19.08.2009 JP 2009190160
(71) Applicant: Kabushiki Kaisha Toshiba, Minato-ku Tokyo (JP)
(72) Inventor: Akaike, Yasuhiko, Tokyo (JP); Natsume, Yoshinori, Tokyo (JP); Ogawa, Masaaki, Tokyo (JP)
(74) Representative: HOFFMANN EITLE

(57) **Abstract**

A light emitting device (1,1a,1b,1c,2,3) includes: a conductive substrate (11); a metal film (13,53) provided above the conductive substrate (11); a light emitting layer (17) provided above the metal film (13,53); an electrode (18) provided partly above the light emitting layer (17); and a current suppression layer (12,12c,42,61) being in contact with the metal film (13,53), provided in a region including at least part of an immediately underlying region of the electrode (18), and configured to suppress current, a first portion (13a,13c,53a) of the metal film (13,53) including at least part of a portion located between the current suppression layer (12,12c,42,61) and the electrode (18), being separated from an portion (13b,13d,53a) other than the first portion (13a,13c,53a).

## Description

### BACKGROUND

Conventionally, in a metal junction LED (light emitting diode), a metal film and a light emitting layer are stacked on a conductive substrate, an upper electrode is provided partly on the light emitting layer, and a lower electrode is provided on the lower surface of the conductive substrate. Application of voltage between the upper electrode and the lower electrode causes recombination of electrons and holes in the light emitting layer, and light emission occurs. Here, light emitted upward from the light emitting layer is directly emitted upward, and light emitted downward is reflected by the metal film and emitted upward, from the LED (see, e.g., JP-A 2009-76490 (Kokai)).

In such a metal junction LED, in the light emitting layer, a current flows most easily in the portion located immediately below the upper electrode, and a large amount of light emission is produced in this portion. However, most of the light generated immediately below the upper electrode is blocked by the upper electrode. This causes the problem of low light extraction efficiency, and hence low overall light emission efficiency of the LED.

### SUMMARY

According to an aspect of the invention, there is provided a light emitting device including: a conductive substrate; a metal film provided above the conductive substrate; a light emitting layer provided above the metal film; an electrode provided partly above the light emitting layer; and a current suppression layer being in contact with the metal film, provided in a region including at least part of an immediately underlying region of the electrode, and configured to suppress current, a first portion of the metal film including at least part of a portion located between the current suppression layer and the electrode, being separated from a portion other than the first portion.

According to another aspect of the invention, there is provided a light emitting device including: a conductive substrate; a metal film provided above the conductive substrate; a light emitting layer provided above the metal film; an electrode provided partly above the light emitting layer; and a current suppression layer provided in a region including at least part of an immediately underlying region of the electrode between the metal film and the light emitting layer and configured to suppress current.

According to still another aspect of the invention, there is provided a method for manufacturing a light emitting device, including: doping a part of an upper portion of a semiconductor substrate of a first conductivity type with a second conductivity type impurity; forming a first metal film above the semiconductor substrate; separating a portion of the first metal film corresponding to a part of an immediately overlying region of the region doped with the second conductivity type impurity from a portion other than the portion of the first metal film; forming a light emitting layer above a support substrate; forming a second metal film above the light emitting layer; processing the second metal film to conform to the first metal film on bringing the second metal film into abutment with the first metal film; laminating the support substrate to the semiconductor substrate by bonding the second metal film to the first metal film; removing the support substrate; and forming an electrode on an exposed surface of the light emitting layer developed by the removing the support substrate, in part of the immediately overlying region of the portion corresponding to the part of the first metal film.

### BRIEF DESCRIPTION OF THE DRAWINGS

FIGS. 1A and 1B are a cross-sectional view and a plan view, respectively, illustrating a light emitting device according to a first embodiment of the invention;
FIG. 2 is a cross-sectional view illustrating a light emitting layer of the light emitting device according to the first embodiment;
FIGS. 3A to 3D are process cross-sectional views illustrating a method for manufacturing the light emitting device according to the first embodiment;
FIGS. 4A to 4C are process cross-sectional views illustrating a method for manufacturing the light emitting device according to the first embodiment;
FIG. 5 is a schematic cross-sectional view illustrating the operation of the light emitting device according to the first embodiment;
FIG. 6 is a cross-sectional view illustrating a light emitting layer of a light emitting device according to a first variation of the first embodiment;
FIGS. 7A and 7B are a cross-sectional view and a plan view, respectively, illustrating a light emitting device according to a second variation of the first embodiment;
FIGS, 8A and 8B are a cross-sectional view and a plan view, respectively, illustrating a light emitting device according to a third variation of the first embodiment;
FIGS. 9A and 9B are a cross-sectional view and a plan view, respectively, illustrating a light emitting device according to a second embodiment of the invention;
FIGS. 10A and 10B are a schematic cross-sectional view and a schematic plan view, respectively, illustrating the operation of the light emitting device according to the second embodiment;
FIGS. 11A and 11B are a cross-sectional view and a plan view, respectively, illustrating a light emitting device according to a third embodiment of the invention;
FIGS. 12A to 12D are process cross-sectional views illustrating a method for manufacturing the light emitting device according to the third embodiment;
FIGS. 13A to 13C are process cross-sectional views illustrating a method for manufacturing the light emitting device according to the third embodiment; and
FIGS. 14A and 14B are a cross-sectional view and a plan view, respectively, illustrating a light emitting device according to a variation of the third invention.

### DETAILED DESCRIPTION

Embodiments of the invention will now be described with reference to the drawings.

At the outset, a first embodiment of the invention is described.

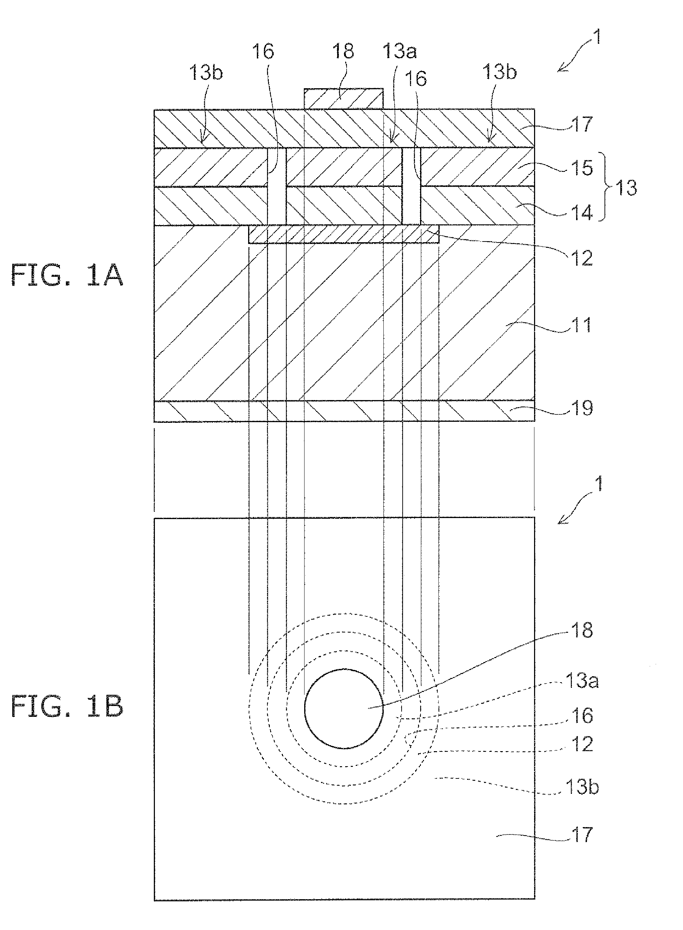

FIGS. 1A and 1B are a cross-sectional view and a plan view, respectively, illustrating a light emitting device according to this embodiment.

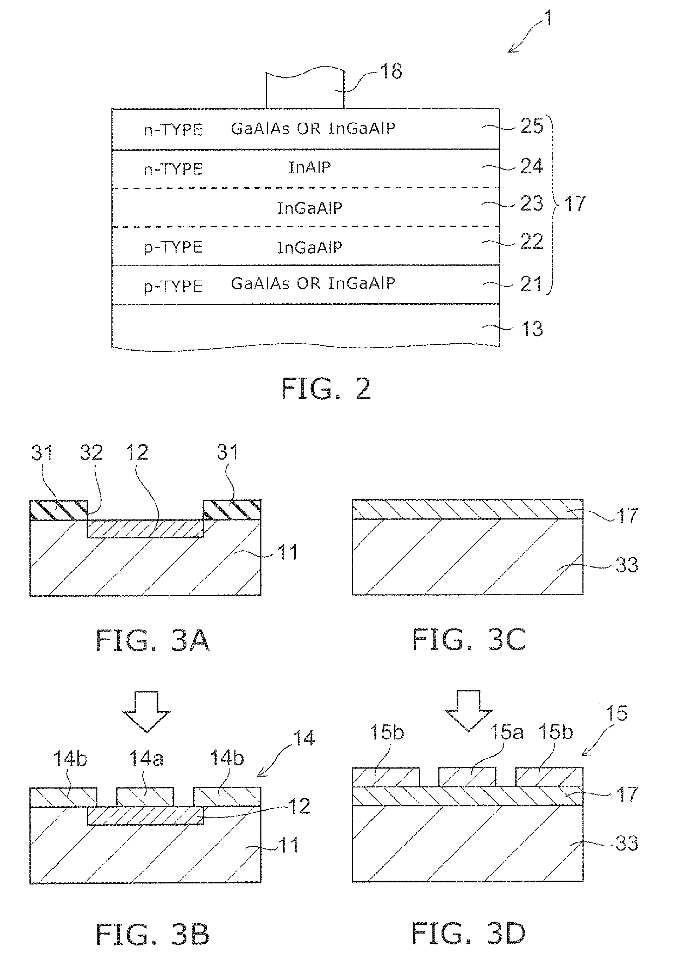

FIG. 2 is a cross-sectional view illustrating a light emitting layer of the light emitting device according to this embodiment.

As shown in FIGS. 1A and 1B, a light emitting device 1 according to this embodiment is a metal junction LED. The light emitting device 1 includes a silicon substrate 11 illustratively made of p-type single crystal silicon. As viewed from above, that is, in the direction perpendicular to the upper surface of the silicon substrate 11, the silicon substrate is shaped like a rectangle. The silicon substrate 11 is provided with conductivity by containing impurity, for example, boron, acting as an acceptor in silicon.

A low-concentration layer 12 is formed in part of the upper portion of the silicon substrate 11. The low-concentration layer 12 is doped with impurity, for example, phosphorus, acting as a donor in silicon. In this specification, such impurity, which turns the conductivity type of the base material to n-type, is also referred to as "n-type impurity", By phosphorus doping, although the conductivity type of the low-concentration layer 12 is p-type, the effective impurity concentration contributing to conduction in the low-concentration layer 12 is lower than the effective impurity concentration in the silicon substrate 11, and hence the resistivity of the low-concentration layer 12 is higher than the resistivity of the silicon substrate 11. As viewed from above, the low-concentration layer 12 is illustratively shaped like a circle, and the center of the low-concentration layer 12 coincides with the center of the silicon substrate 11. Here, as viewed from above, in the case where the silicon substrate 11 is illustratively shaped like a rectangle, the center of the silicon substrate 11 is the point of intersection of its diagonals.

A metal film 13 is provided entirely on the silicon substrate 11. The metal film 13 is illustratively made of gold (Au) and composed of a lower film 14 and an upper film 15 stacked thereon. The metal film 13 includes a trench 16 piercing the metal film 13 in the film thickness direction. As viewed from above, the trench 16 is located inside the low-concentration layer 12 and has an annular shape. The space inside the trench 16 is a gas layer or a vacuum layer and is illustratively an air layer. By the trench 16, a circular portion 13a of the metal film 13 corresponding to part of the immediately overlying region of the low-concentration layer 12 is separated from a surrounding portion 13b.

A light emitting layer 17 is provided entirely on the metal film 13. As shown in FIG. 2, in the light emitting layer 17, sequentially from the bottom, a lower cladding layer 21, a p-type cladding layer 22, an active layer 23, an n-type cladding layer 24, and a current diffusion layer 25 are stacked. By way of example, the light emitting device 1 is a device for emitting red to green light at a wavelength of 640-500 nm (nanometers), the lower cladding layer 21 is made of p-type GaAlAs or InGaAlP, the p-type cladding layer 22 is made of p-type InAlP, the active layer 23 is made of InGaAlP, the n-type cladding layer 24 is made of n-type InAlP, and the current diffusion layer 25 is made of n-type GaAlAs or InGaAlP.

An upper electrode 18 is provided partly on the light emitting layer 17. As viewed from above, the upper electrode 18 is shaped like a circle and located inside the trench 16, that is, inside the portion 13a of the metal film 13. Furthermore, as viewed from above, the upper electrode 18 is located in a region including the center of the light emitting layer 17. On the other hand, a lower electrode 19 is provided entirely on the lower surface of the silicon substrate 11. The upper electrode 18 and the lower electrode 19 are made of metal.

That is, in the light emitting device 1 as viewed from above, sequentially from outside, the circular low-concentration layer 12, the annular trench 16, and the circular upper electrode 18 are concentrically arranged, and the centers thereof illustratively coincide with the center of the silicon substrate 11. Hence, the low-concentration layer 12 is provided in a region including the immediately underlying region of the upper electrode 18 on the lower surface of the metal film 13. Furthermore, the portion 13a of the metal film 13 is located in a region including at least part of the immediately underlying region of the upper electrode 18 and corresponding to part of the immediately overlying region of the low-concentration layer 12. In other words, the portion 13a includes at least part of the portion located between the low-concentration layer 12 and the upper electrode 18.

The dimension of each portion of the light emitting device 1 is illustratively as follows. As viewed from above, the length of one side of the silicon substrate 11, that is, the length of one side of the light emitting device 1 is 300 µm (microns). The outer diameter of the trench 16 is 130-140 µm. The inner diameter of the trench 16, that is, the diameter of the portion 13a of the metal film 13 is 120 µm. The diameter of the upper electrode 18 is 100 µm. The thickness of the silicon substrate 11 is 300-400 µm, The film thickness of the lower film 14 and the upper film 15 is 1 µm each.

Next, a method for manufacturing the light emitting device 1 according to this embodiment is described.

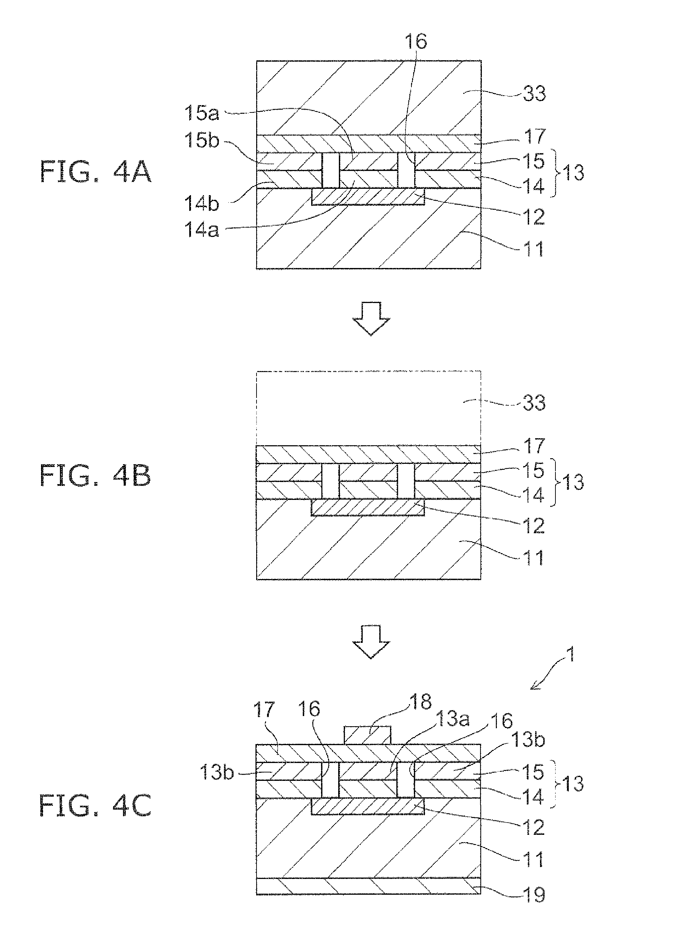

FIGS. 3A to 3D and FIGS. 4A to 4C are process cross-sectional views illustrating the method for manufacturing a light emitting device according to this embodiment.

First, as shown in FIG. 3A, a p-type silicon substrate 11 is prepared. Next, a barrier film 31 illustratively made of silicon oxide is formed entirely on the silicon substrate 11. Next, an opening 32 is formed in a region of the barrier film 31 where a low-concentration layer 12 is to be formed. Next, the silicon substrate 11 is exposed to an atmosphere containing n-type impurity, such as phosphorus. Thus, phosphorus is adsorbed on the region of the upper surface of the silicon substrate 11 exposed through the opening 32. Subsequently, heat treatment is performed, This causes phosphorus adsorbed on the upper surface of the silicon substrate 11 to be diffused into the silicon substrate 11 and activated. Thus, part of the upper portion of the p-type silicon substrate 11 is doped with n-type impurity, or phosphorus, and the effective impurity concentration therein is decreased, forming a low-concentration layer 12. Subsequently, the barrier film 31 is removed.

Next, as shown in FIG. 3B, a lower film 14 illustratively made of gold is formed entirely on the silicon substrate 11 illustratively by the vacuum evaporation process. Next, the lower film 14 is patterned illustratively by lithography so that a portion 14a of the lower film 14 corresponding to part of the immediately overlying region of the low-concentration layer 12 is separated from the other portion 14b. The portions 14a and 14b of the lower film 14 will constitute, in a later process, the lower portion of the portions 13a and 13b of the metal film 13, respectively.

On the other hand, as shown in FIG. 3C, a support substrate 33 is prepared. For instance, in the case where the light emitting device 1 is a device for emitting red to green light at a wavelength of 640-500 nm, a gallium arsenide (GaAs) substrate is used as the support substrate 33. Next, a light emitting layer 17 is formed on the support substrate 33. Here, the light emitting layer 17 is stacked sequentially from its upper layer, that is, the layer to be located far from the silicon substrate 11 in the completed light emitting device 1.

Specifically, as shown in FIG. 2, a current diffusion layer 25 made of n-type InGaAlP or GaAlAs is formed on the support substrate 33 illustratively by the MOCVD (metal organic chemical vapor deposition) or MBE (molecular beam epitaxy) process, an n-type cladding layer 24 made of n-type InAlP is formed thereon, an active layer 23 made of InGaAlP is formed thereon, a p-type cladding layer 22 made of p-type InAlP is formed thereon, and a lower cladding layer 21 made of p-type GaAlAs or InGaAlP is formed thereon. The raw material used in the MOCVD process is illustratively an organic metal such as TMG (trimethylgailium), TMA (trimethylaluminum), or TMI (trimethylindium), or a hydride gas such as arsine (AsH₃) or phosphine (PH₃). The p-type impurity for GaAs can be zinc (Zn) or the like made from DMZ (dimethylzinc), and the n-type impurity can be silicon (Si) or the like.

Next, as shown in FIG. 3D, an upper film 15 made of gold is formed on the light emitting layer 17 illustratively by the vacuum evaporation process. Next, the upper film 15 is patterned illustratively by lithography so that a circular portion 15a is separated from a surrounding portion 15b. Thus, the upper film 15 is processed so as to conform to the lower film 14 when brought into abutment with the lower film 14 in a later process.

Next, as shown in FIG. 4A, the upper film 15 is brought into abutment with and bonded to the lower film 14, and thereby the support substrate 33 is laminated to the silicon substrate 11. For instance, at room temperature, the upper film 15 is brought into contact with the lower film 14 and heated for e.g. 30 minutes in the temperature range of e.g. 100 -200°C. Thus, the upper film 15 is bonded to the lower film 14. This lamination is preferably performed in a vacuum or an inert gas atmosphere because it enhances contact between the upper film 15 and the lower film 14. By bonding the upper film 15 to the lower film 14, a metal film 13 is formed. The gap between the portion 14a and the portion 14b in the lower film 14 communicates with the gap between the portion 15a and the portion 15b in the upper film 15, and the gaps form an annular trench 16.

Next, as shown in FIG. 4B, the support substrate 33 is removed by wet etching. Thus, the upper surface of the light emitting layer 17 is exposed.

Next, as shown in FIG. 4C, an upper electrode 18 is partly formed on the upper surface of the light emitting layer 17, that is, on the exposed surface of the light emitting layer 17 developed by the removal of the support substrate 33. The upper electrode 18 is formed circularly in part of the immediately overlying region of the circular portion 13a of the metal film 13. On the other hand, a lower electrode 19 is formed entirely on the lower surface of the silicon substrate 11. Thus, the light emitting device 1 is manufactured.

Next, the operation and effect of this embodiment are described.

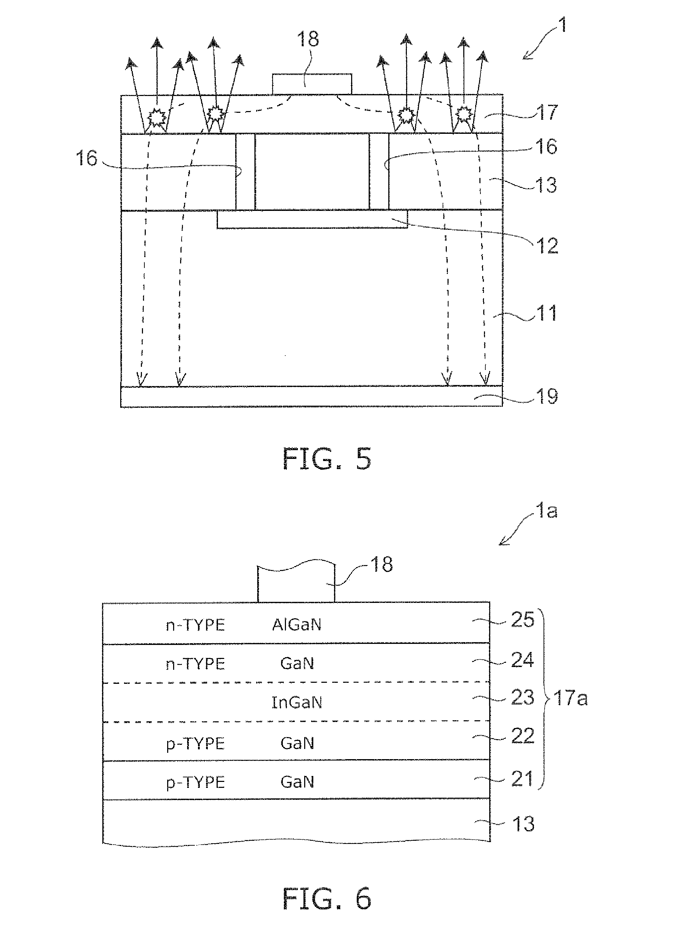

FIG. 5 is a schematic cross-sectional view illustrating the operation of the light emitting device according to this embodiment.

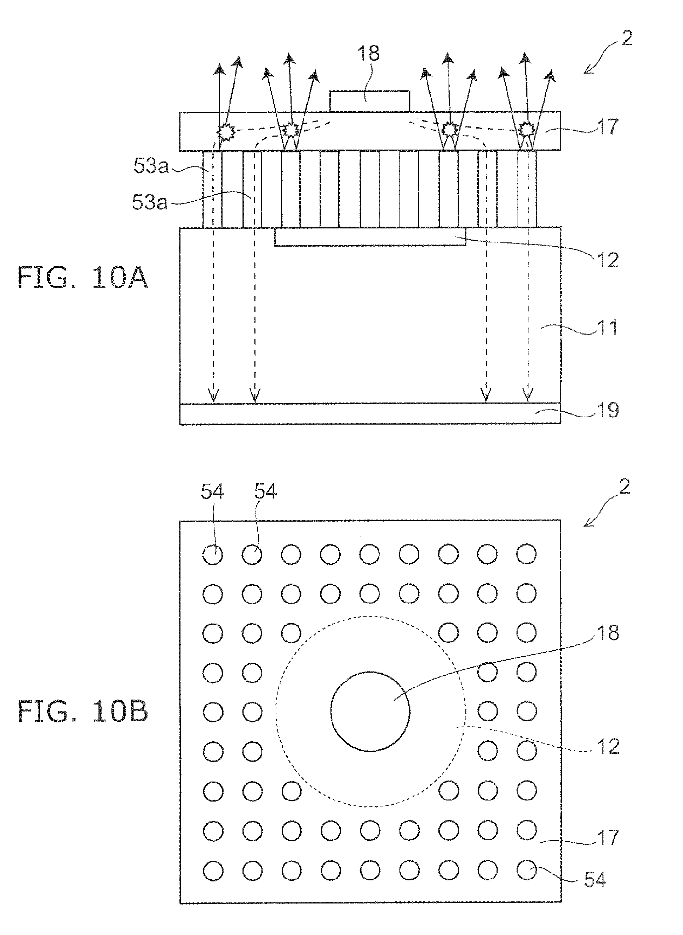

In FIG. 5, the dashed arrow indicates a current path, and the solid arrow indicates an optical path. It is noted that FIG. 5 illustrates part of innumerable current paths and optical paths. Furthermore, the direction of the arrow indicating the current path is arbitrary and not necessarily directed from the positive pole to the negative pole. This also applies to FIGS. 10A and 10B described later.

As shown in FIG. 5, in the light emitting device 1 according to this embodiment, wirings (not shown) are bonded to the upper electrode 18 and the lower electrode 19 to apply a voltage between the upper electrode 18 and the lower electrode 19 and pass a current therebetween. Thus, in the active layer 23 (see FIG. 2) of the light emitting layer 17, electrons and holes are recombined, and an energy corresponding to the band gap is emitted as light. Light emitted upward from the light emitting layer 17 is directly emitted upward, and light emitted downward is reflected by the metal film 13 and then emitted upward, from the light emitting device 1.

Here, the low-concentration layer 12 has a lower effective impurity concentration and a higher resistivity than the silicon substrate 11 and hence functions as a current suppression layer for suppressing the passage of current. Furthermore, the current flows freely in the metal film 13 except the trench 16, but no current flows in the trench 16 because its inside is a gas layer or a vacuum layer. In the light emitting device 1, the low-concentration layer 12 serving as a current suppression layer is provided on the lower surface of the metal film 13 and in contact with the entire lower surface of the portion 13a. Hence, little current flows in the portion 13a.

Consequently, the current flowing between the upper electrode 18 and the lower electrode 19 scarcely passes in the portion 13a, but passes primarily in the portion 13b. Hence, also in the light emitting layer 17, the current does not substantially flow in the portion between the upper electrode 18 and the portion 13a, but flows intensively in the portion between the upper electrode 18 and the portion 13b. Thus, light emission in the light emitting layer 17 occurs primarily in the portion except immediately below the upper electrode 18. Hence, the light generated in the light emitting layer 17 is less likely to be blocked by the upper electrode 18. Thus, in the light emitting device 1, the light generated in the light emitting layer 17 is blocked by the upper electrode 18 in a smaller proportion, achieving high light extraction efficiency, and high overall light emission efficiency of the light emitting device. In particular, in this embodiment, the portion 13a is located in a region entirely including the immediately underlying region of the upper electrode 18. Hence, the light emitted from the light emitting layer 17 is less likely to be blocked by the upper electrode 18, achieving high light emission efficiency.

Furthermore, as viewed from above, the upper electrode 18 is located in a region including the center of the light emitting layer 17. Hence, the current isotropically spreads around the immediately underlying region of the upper electrode 18 and can cause the surroundings of the immediately underlying region of the upper electrode 18 in the light emitting layer 17 to emit light nearly uniformly.

Furthermore, in the light emitting device 1, the portion 13a of the metal film 13 is provided immediately below the upper electrode 18, and hence high mechanical strength is achieved. This can prevent destruction of the light emitting layer 17 when wirings are bonded to the upper electrode 18.

Moreover, in this embodiment, the low-concentration layer 12 is formed by doping the p-type silicon substrate 11 with n-type impurity, or phosphorus, and used as a current suppression layer. Hence, the current suppression layer can be formed easily. Furthermore, formation of the current suppression layer does not impair the flatness of the upper surface of the silicon substrate 11. Consequently, the upper surface of the lower film 14 can also be formed flat and bonded to the upper film 15 with high accuracy.

In the example described in this embodiment, the conductivity type of the silicon substrate 11 is p-type, the conductivity type of the lower portion of the light emitting layer 17 is p-type, and the conductivity type of the upper portion thereof is n-type. However, these conductivity types may be reversed. In other words, the conductivity type of the silicon substrate 11 may be n-type, the conductivity type of the lower portion of the light emitting layer 17 may be n-type, and the conductivity type of the upper portion thereof may be p-type. Specifically, in the light emitting layer 17, sequentially from the bottom, a lower cladding layer made of n-type GaAlAs or InGaAlP, an n-type cladding layer made of n-type InAlP, an active layer made of InGaAlP, a p-type cladding layer made of p-type InAlP, and a current diffusion layer made of p-type InGaAlP or GaAlAs may be stacked. In this case, the low-concentration layer 12 is doped with p-type impurity.

Furthermore, in the example described in this embodiment, phosphorus is adsorbed on part of the upper surface of the silicon substrate 11, which is then heat treated to diffuse and activate the adsorbed phosphorus to form a low-concentration layer 12. However, the silicon substrate 11 may be doped with phosphorus by ion implantation. In this case, the acceleration energy needs to be sufficiently lowered so that phosphorus is implanted only into the upper portion of the silicon substrate 11.

Next, a first variation of this embodiment is described.

FIG. 6 is a cross-sectional view illustrating a light emitting layer of a light emitting device according to this variation.

As shown in FIG. 6, a light emitting device 1a according to this variation is a device for emitting blue to ultraviolet light at a wavelength of 480-400 nm. The light emitting device 1a according to this variation is different from the light emitting device 1 according to the above first embodiment in the composition of the light emitting layer. More specifically, in a light emitting layer 17a of the light emitting device 1a, for instance, the lower cladding layer 21 is made of p-type GaN, the p-type cladding layer 22 is also made of p-type GaN, the active layer 23 is made of InGaN, the n-type cladding layer 24 is made of n-type GaN, and the current diffusion layer 25 is made of n-type AlGaN.

Furthermore, the support substrate 33 serving as a foundation for depositing such a light emitting layer 17a is also different from that of the above first embodiment. More specifically, in this variation, a sapphire substrate is used as the support substrate 33. Furthermore, after the support substrate 33 is laminated to the silicon substrate 11, the support substrate 33 is removed not by wet etching, but illustratively by the laser lift-off process. The configuration, manufacturing method, operation, and effect in this variation other than the foregoing are the same as those in the above first embodiment.

Next, a second variation of this embodiment is described.

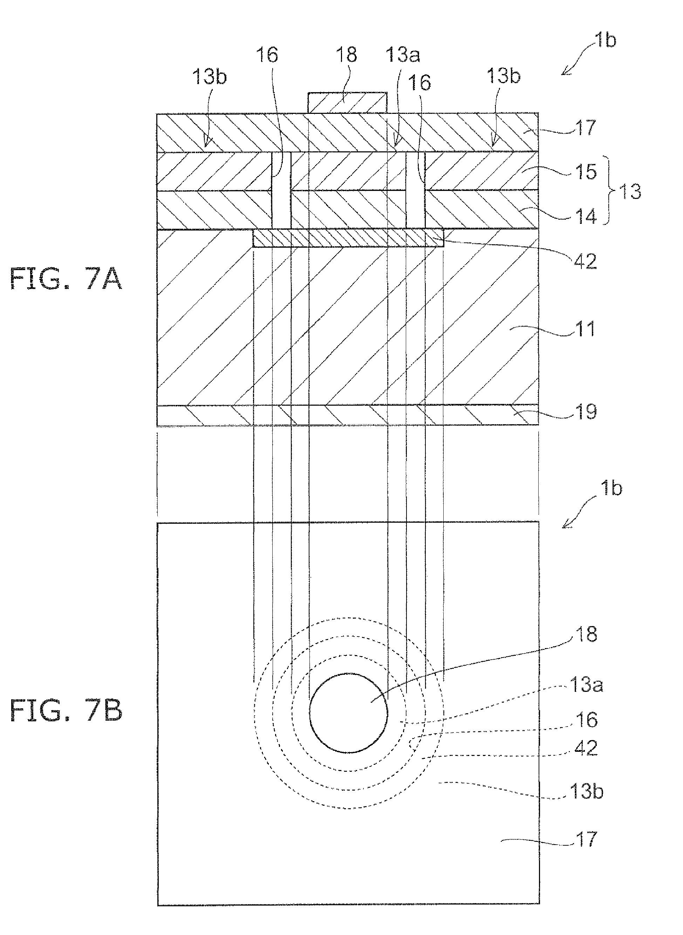

FIGS. 7A and 7B are a cross-sectional view and a plan view, respectively, illustrating a light emitting device according to this variation.

As shown in FIGS. 7A and 7B, a light emitting device 1b according to this variation includes an opposite conductivity type layer 42 instead of the low-concentration layer 12 (see FIGS. 1A and 1B) of the light emitting device 1 according to the above first embodiment. The opposite conductivity type layer 42 is a layer whose conductivity type is opposite to that of the surroundings of the opposite conductivity type layer 42, that is, to the conductivity type of the silicon substrate 11. In this variation, the conductivity type of the silicon substrate 11 is p-type, whereas the conductivity type of the opposite conductivity type layer 42 is n-type.

The opposite conductivity type layer 42 can be formed by, in the process shown in FIG. 3A, introducing a larger amount of n-type impurity, or phosphorus, than in forming the low-concentration layer 12. Consequently, the opposite conductivity type layer 42 contains n-type impurity at a higher concentration than the low-concentration layer 12, and its conductivity type becomes n-type. The configuration and manufacturing method in this variation other than the foregoing are the same as those in the above first embodiment.

In this variation, a pn junction is formed at the interface between the p-type silicon substrate 11 and the n-type opposite conductivity type layer 42, thereby suppressing the passage of current. That is, in the light emitting device 1b, the opposite conductivity type layer 42 functions as a current suppression layer. The operation and effect in this variation other than the foregoing are the same as those in the above first embodiment.

Next, a third variation of this embodiment is described.

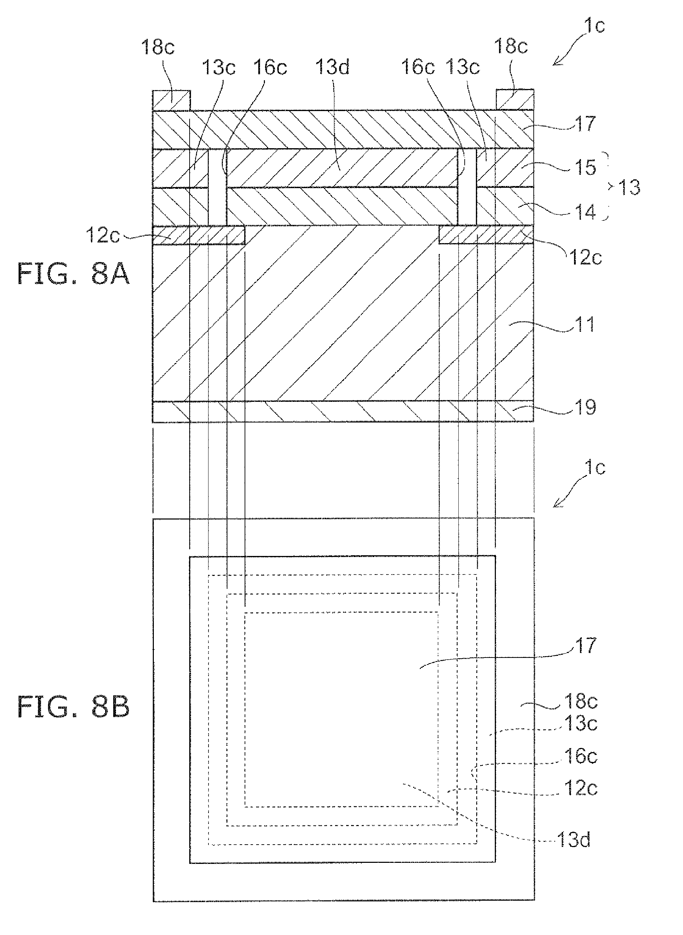

FIGS. 8A and 8B are a cross-sectional view and a plan view, respectively, illustrating a light emitting device according to this variation.

As shown in FIGS. 8A and 8B, in a light emitting device 1c according to this variation, as viewed from above, a low-concentration layer 12c, a trench 16c, and an upper electrode 18c are formed like a frame along the outer edge of the silicon substrate 11. Hence, in the metal film 13, the current can be passed not in the frame-shaped portion 13c, but in a rectangular portion 13d located inside it, enabling the portion of the light emitting layer 17 immediately above the rectangular portion 13d to emit light. Thus, the layout of the current suppression layer (low-concentration layer 12), the trench, and the upper electrode is arbitrary as long as, as viewed from above, a current suppression layer is formed in a region including at least part of the upper electrode and a portion of the metal film 13 including at least part of the immediately underlying region of the upper electrode and corresponding to part of the immediately overlying region of the current suppression layer is separated from the other portion. The configuration, manufacturing method, operation, and effect in this variation other than the foregoing are the same as those in the above first embodiment.

Next, a second embodiment of the invention is described.

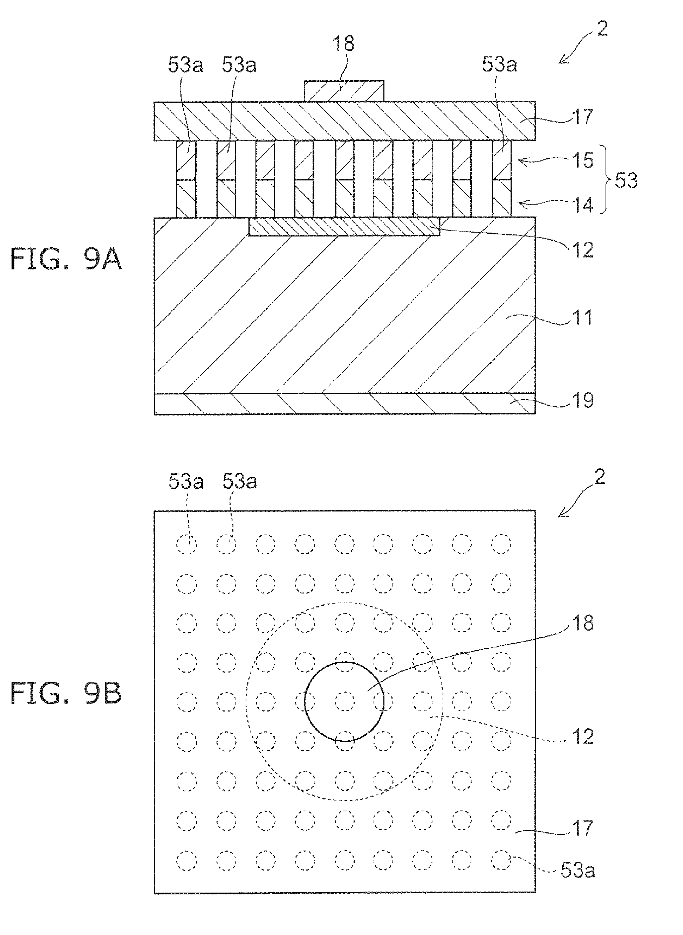

FIGS. 9A and 9B are a cross-sectional view and a plan view, respectively, illustrating a light emitting device according to this embodiment.

As shown in FIGS. 9A and 9B, in a light emitting device 2 according to this embodiment, the metal film 53 is divided into a plurality of pillars 53a. Each of the pillars 53a is shaped like a cylinder. As viewed from above, the pillars 53a are arranged illustratively in a matrix and separated from each other. Such pillars 53a can be manufactured by, in the above processes shown in FIGS. 3B and 3D, patterning and dividing the upper film 15 and the lower film 14 into a plurality of pillars, The configuration and manufacturing method in this embodiment other than the foregoing are the same as those in the above first embodiment.

Next, the operation and effect of this embodiment are described.

FIGS. 10A and 10B are a schematic cross-sectional view and a schematic plan view, respectively, illustrating the operation of the light emitting device according to this embodiment.

As shown in FIG. 10, in the light emitting device 2 according to this embodiment, the pillar 53a located immediately above the low-concentration layer 12 is in contact with the low-concentration layer 12 and separated from the other pillars 53a. Hence, the current does not substantially flow in the pillar 53a in contact with the low-concentration layer 12, but flows intensively in the pillars 53a in contact with the silicon substrate 11, that is, in the pillars 53a (hereinafter referred to as "current passing pillars") located in the region except immediately above the low-concentration layer 12. Consequently, in the light emitting layer 17, a portion 54 corresponding to the immediately overlying region of the current passing pillars intensively emits light. Furthermore, the upper electrode 18 is not located immediately above this light emitting portion 54. Hence, the emitted light is not blocked by the upper electrode 18. Consequently, the light emitting device 2 has high light emission efficiency.

Furthermore, in general, the density of light emission is not linearly related to the density of current flowing in the light emitting layer, but there exists a current density for maximizing the light emission efficiency, and its value depends on the composition of the light emitting layer. In this embodiment, the number, arrangement, cross-sectional area and the like of the pillars 53a can be adjusted to control the density of current flowing in each portion of the light emitting layer 17. Thus, the current can be passed in the light emitting layer 17 at the current density for maximizing the light emission efficiency. Consequently, the light emission efficiency can be further improved. The operation and effect in this embodiment other than the foregoing are the same as those in the above first embodiment.

In the example described in this embodiment, the pillars 53a are arranged in a matrix. However, the invention is not limited thereto. For instance, the pillars 53a may be arranged concentrically, radially, or randomly.

Next, a third embodiment of the invention is described.

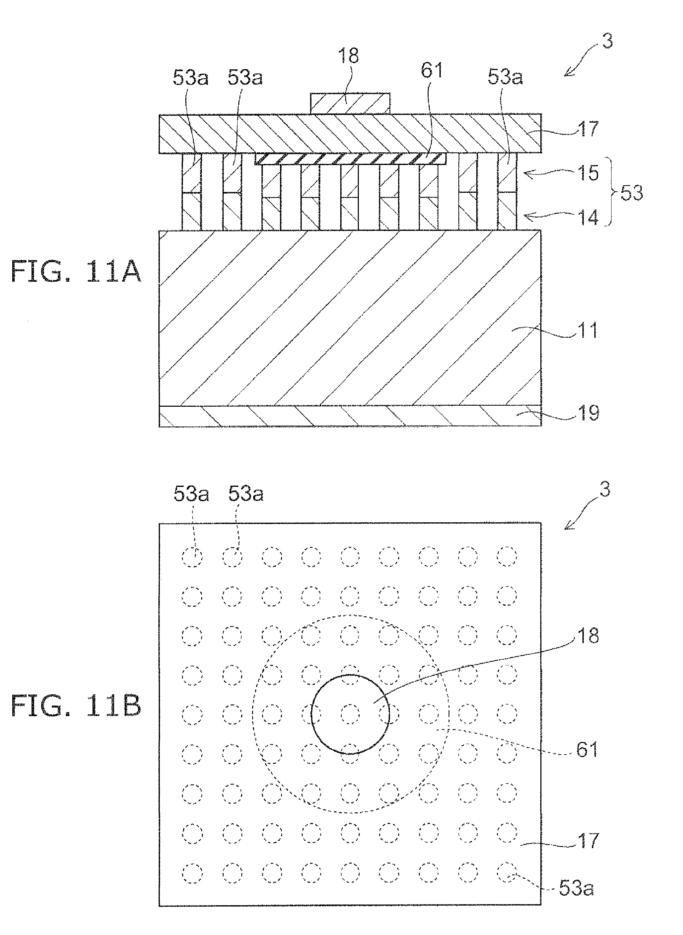

FIGS. 11A and 11B are a cross-sectional view and a plan view, respectively, illustrating a light emitting device according to this embodiment.

As shown in FIGS. 11A and 11B, a light emitting device 3 according to this embodiment is different from the light emitting device 2 (see FIGS. 9A and 9B) according to the above second embodiment in including no low-concentration layer 12 (see FIGS. 9A and 9B) but instead including an insulating layer 61 between the metal film 53 and the light emitting layer 17. The insulating layer 61 is formed from an insulating material, such as silicon oxide. As viewed from above, the insulating layer 61 is shaped like a circle, with its outer edge lying outside the outer edge of the upper electrode 18, and its center coinciding with the center of the upper electrode 18 and the light emitting layer 17. In the case where the film thickness of the lower film 14 and the upper film 15 of the metal film 53 is illustratively 1 µm each, the thickness of the insulating layer 61 is illustratively 50 µm or less. The configuration in this embodiment other than the foregoing is the same as that in the above second embodiment.

Next, a method for manufacturing the light emitting device 3 according to this embodiment is described.

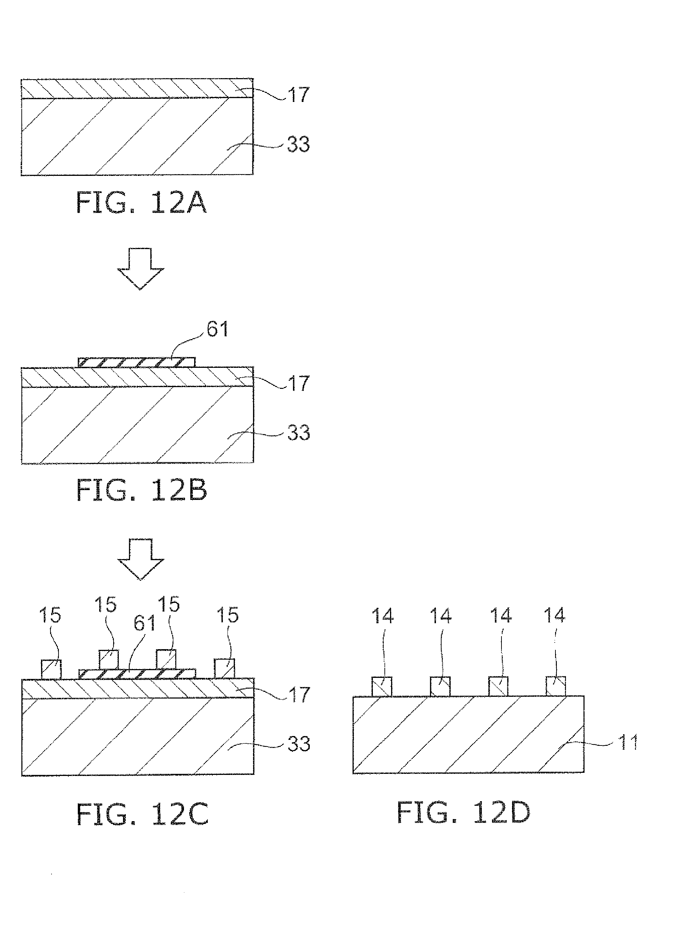

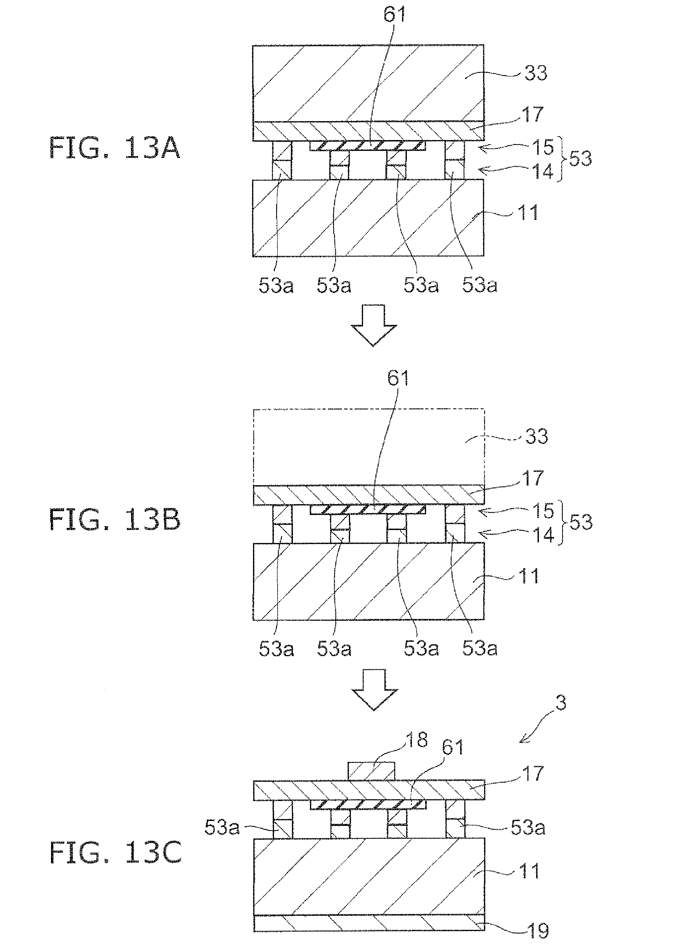

FIGS. 12A to 12D and FIGS. 13A to 13C are process cross-sectional views illustrating the method for manufacturing a light emitting device according to this embodiment.

First, as shown in FIG. 12A, as in the above first embodiment, a light emitting layer 17 is formed on a support substrate 33.

Next, as shown in FIG. 12B, an insulating layer 61 made of silicon oxide is formed on the light emitting layer 17. The insulating layer 61 is formed circularly on the center region of the light emitting layer 17.

Next, as shown in FIG. 12C, an upper film 15 is formed entirely on the light emitting layer 17 so as to cover the insulating layer 61 and divided into a plurality of pillars. Thus, the pillars formed in part of the immediately overlying region of the insulating layer 61 are separated from the pillars formed in the region except immediately above the insulating layer 61.

On the other hand, as shown in FIG. 12D, a lower film 14 is formed entirely on a p-type silicon substrate 11. Here, the silicon substrate 11 is not doped with n-type impurity, and hence the low-concentration layer 12 (see FIGS. 1A and 1B) and the opposite conductivity type layer 42 (see FIGS. 7A and 7B) are not formed. Next, the lower film 14 is divided into a plurality of pillars and processed so as to conform to the upper film 15 when brought into abutment with the upper film 15.

Next, as shown in FIG. 13A, the upper film 15 is brought into abutment with the lower film 14, and thereby the support substrate 33 is laminated to the silicon substrate 11. Thus, the plurality of pillars made from the upper film 15 are respectively bonded to the plurality of pillars made from the lower film 14, forming a plurality of pillars 53a.

Here, of the pillars made by division of the upper film 15, the pillars formed immediately above the insulating layer 61 protrude by the amount of the thickness of the insulating layer 61 relative to the pillars formed in the other region. However, because the upper film 15 and the lower film 14 are formed from gold, which is soft, each of the pillars can deform and absorb the step difference due to the amount of the thickness of the insulating layer 61. Conversely, the thickness of the insulting layer 61 is such that it can be absorbed by deformation of the upper film 15 and the lower film 14.

Next, as shown in FIG. 13B, the support substrate 33 is removed by wet etching. Thus, the upper surface of the light emitting layer 17 is exposed.

Next, as shown in FIG. 13C, an upper electrode 18 is formed partly on the upper surface of the light emitting layer 17. As viewed from above, the upper electrode 18 is formed circularly inside the insulating layer 61. On the other hand, a lower electrode 19 is formed entirely on the lower surface of the silicon substrate 11. Thus, the light emitting device 3 is manufactured. The configuration and manufacturing method in this embodiment other than the foregoing are the same as those in the above first embodiment.

In the light emitting device 3 according to this embodiment, the insulating layer 61 functions as a current suppression layer. Hence, the current can be suppressed more reliably than in the case of using the low-concentration layer 12 or the opposite conductivity type layer 42 as a current suppression layer as in the above first and second embodiments and the variations thereof. The operation and effect in this embodiment other than the foregoing are the same as those in the above second embodiment.

In the example described in this embodiment, the insulating layer 61 is formed between the metal film 53 and the light emitting layer 17. However, the invention is not limited thereto, but the insulating layer 61 may be formed between the silicon substrate 11 and the metal film 53. Furthermore, in the example described in this embodiment, as in the above second embodiment, the metal film 53 is divided into a plurality of pillars 53a. However, as in the above first embodiment, a trench may be formed in the metal film so that the portion of the metal film including the immediately underlying region of the upper electrode 18 and included in the immediately underlying or overlying region of the insulating layer 61 is separated from the other portion.

Next, a variation of this embodiment is described.

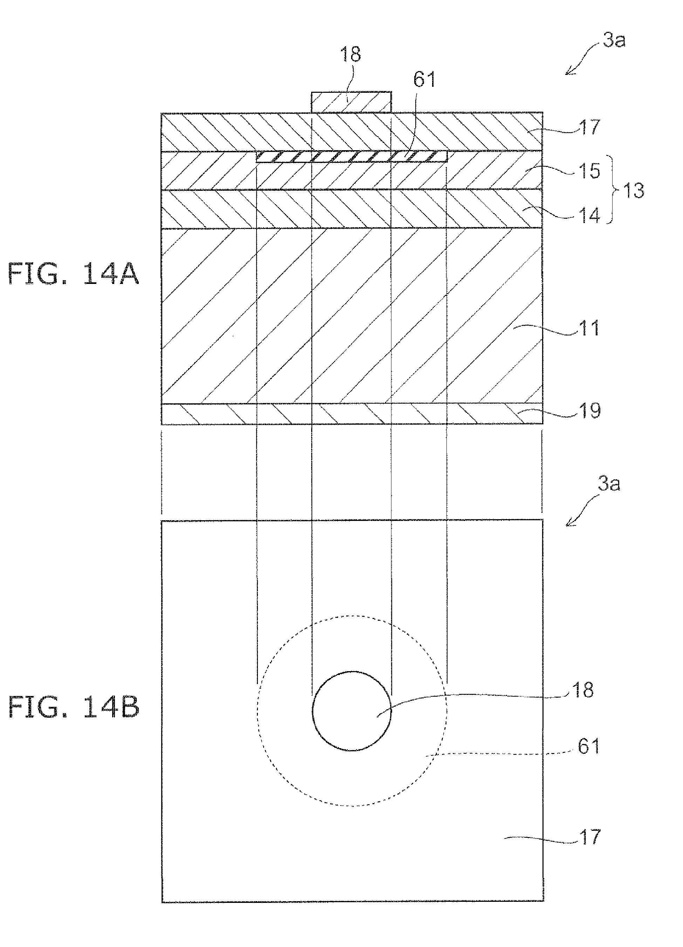

FIGS. 14A and 14B are a cross-sectional view and a plan view, respectively, illustrating a light emitting device according to this variation.

As shown in FIGS. 14A and 14B, a light emitting device 3a according to this variation is different from the light emitting device 3 (see FIGS. 11A and 11B) according to the above third embodiment in that the metal film 13 is not divided. In this variation, in contrast to the above third embodiment, because the metal film 13 is not divided, the metal film 13 is resistant to deformation, and it is slightly more difficult to absorb the thickness of the insulating layer 61 by deformation of the metal film 13 and uniformly bond the lower film 14 and the upper film 15. However, because there is no need to process the metal film 13, the manufacturing process can be simplified as compared with the third embodiment. The configuration, manufacturing method, operation, and effect in this variation other than the foregoing are the same as those in the above third embodiment. In the example described in the third embodiment and this variation, the current suppression layer is made of the insulating layer 61. However, the invention is not limited thereto, but the current suppression layer may be made of a low-concentration layer or opposite conductivity type layer with respect to the light emitting layer 17.

The invention has been described with reference to the embodiments and the variations thereof. However, the invention is not limited to these embodiments and variations. The above embodiments can be practiced in combination with each other. For instance, the variations described in the above first embodiment and its variations are applicable to the above second and third embodiments. For instance, in the above second embodiment, as a current suppression layer, an opposite conductivity type layer may be provided instead of the low-concentration layer. Furthermore, in the embodiments, the low-concentration layer or the opposite conductivity type layer, and an insulating layer may be both provided.

Furthermore, those skilled in the art can suitably vary the above embodiments and variations by addition, deletion, or design change of components, or by addition, omission, or condition change of processes, and such modifications are also encompassed within the scope of the invention as long as they fall within the spirit of the invention, For instance, to ensure the bonding strength between the light emitting layer and the upper electrode, a contact layer may be provided therebetween. Furthermore, the configuration and composition of the light emitting layer are not limited to the examples described above.

## Claims

1. A light emitting device (1,1a,1b,1c,2,3) comprising:
a conductive substrate (11);
a metal film (13,53) provided above the conductive substrate (11);
a light emitting layer (17) provided above the metal film (13);
an electrode (18) provided partly above the light emitting layer (17); and
a current suppression layer (12,12c,42,61) being in contact with the metal film (13,53), provided in a region including at least part of an immediately underlying region of the electrode (18), and configured to suppress current,
a first portion (13a,13c,53a) of the metal film (13,53) including at least part of a portion located between the current suppression layer (12,12c,42,61) and the electrode (18), being separated from a portion (13b,13d,53a) other than the first portion (13a,13c,53a).

2. The device according to claim 1, wherein
the conductive substrate (11) is a semiconductor substrate of a first conductivity type, and
the current suppression layer (12,12c) is a semiconductor layer formed in an upper portion of the semiconductor substrate (11) and doped with a second conductivity type impurity.

3. The device according to claim 2, wherein the current suppression layer (12) is a semiconductor layer of a first conductivity type having a lower effective impurity concentration than the effective impurity concentration in the semiconductor substrate (11).

4. The device according to claim 2, wherein the current suppression layer (12c) is a semiconductor layer of the second conductivity type.

5. A light emitting device (3,3a) comprising:
a conductive substrate (11);
a metal film (13,53) provided above the conductive substrate (11);
a light emitting layer (17) provided above the metal film(13,53);
an electrode (18) provided partly above the light emitting layer (17); and
a current suppression layer (61) provided in a region including at least part of an immediately underlying region of the electrode (18) between the metal film (13,53)and the light emitting layer (17) and configured to suppress current.

6. The device according to claim 1 or 5, wherein the current suppression layer (61) is an electrical insulating layer.

7. The device according to any of claims 1-6, wherein the metal film (53) is a plurality of pillars (53a).

8. The device according to any of claims 1-7, wherein the first portion (13a,13c) is located in a region entirely including the immediately underlying region of the electrode (18).

9. The device according to any of claims 1-8, wherein a space (16,16c) is formed between the first portion (13a,13c) and the portion (13b,13d) other than the first portion.

10. The device according to any of claims 1-9, wherein the electrode (18) is located in a region including the center of the light emitting layer (17) as viewed from above.

11. The device according to any of claims 1-10, wherein the light emitting layer (17) includes:
a lower cladding layer (21) provided above the metal film (13) and made of GaAlAs or InGaAlP of a first conductivity type;
a first conductivity type cladding layer (22) provided above the lower cladding layer (21) and made of InAlP of the first conductivity type;
an active layer (23) provided above the first conductivity type cladding layer (22) and made of InGaAlP;
a second conductivity type cladding layer (24) provided above the active layer (23) and made of InAlP of a second conductivity type; and
a current diffusion layer (25) provided above the second conductivity type cladding layer (24) and made of InGaAlP or GaAlAs of the second conductivity type.

12. The device according to any of claims 1-10, wherein the light emitting layer includes:
a lower cladding layer (21) provided above the metal film (13) and made of GaN of a first conductivity type;
a first conductivity type cladding layer (22) provided above the lower cladding layer (21) and made of GaN of the first conductivity type;
an active layer (23) provided above the first conductivity type cladding layer (22) and made of InGaN;
a second conductivity type cladding layer (24) provided above the active layer (23) and made of GaN of a second conductivity type; and
a current diffusion layer (25) provided above the second conductivity type cladding layer (24) and made of AlGaN of the second conductivity type.

13. The device according to any of claims 1-12, further comprising:
another electrode (19) provided above a lower surface of the conductive substrate (11).

14. A method for manufacturing a light emitting device, comprising:
doping a part of an upper portion of a semiconductor substrate (11) of a first conductivity type with a second conductivity type impurity;
forming a first metal film (14) above the semiconductor substrate (11);
separating a portion (14a) of the first metal film (14) corresponding to a part of an immediately overlying region of the region doped with the second conductivity type impurity from a portion (14b) other than the portion of the first metal film (14);
forming a light emitting layer (17) above a support substrate (33);
forming a second metal film (15) above the light emitting layer (17);
processing the second metal film (15) to conform to the first metal film (14) on bringing the second metal film (15) into abutment with the first metal film (14);
laminating the support substrate (33) to the semiconductor substrate (11) by bonding the second metal film (15) to the first metal film (14);
removing the support substrate (33); and
forming an electrode (18) on an exposed surface of the light emitting layer (17) developed by the removing the support substrate (33), in part of the immediately overlying region of the portion corresponding to the part (14a) of the first metal film (14).

15. The method according to claim 14, wherein the separating a portion of the first metal film (14) includes dividing the first metal film (14) into a plurality of pillars (53a).

16. The method according to claim 14 or 15, wherein
the support substrate (33) is a GaAs substrate,
the forming a light emitting layer (17) includes:
forming a current diffusion layer (25) made of InGaAlP or GaAlAs of the second conductivity type;
forming a second conductivity type cladding layer (24) made of InAlP of the second conductivity type above the current diffusion layer (25);
forming an active layer (23) made of InGaAlP above the second conductivity type cladding layer (24);
forming a first conductivity type cladding layer (22) made of InAlP of the first conductivity type above the active layer (23); and
forming a lower cladding layer (21) made of GaAlAs or InGaAlP of the first conductivity type above the first conductivity type cladding layer (22), and
the removing the support substrate (33) is performed by wet etching.

17. The method according to claim 14 or 15, wherein
the support substrate (33) is a sapphire substrate,
the forming a light emitting layer (17a) includes:
forming a current diffusion layer (25) made of AlGaN of the second conductivity type;
forming a second conductivity type cladding layer (24) made of GaN of the second conductivity type above the current diffusion layer (25);
forming an active layer (23) made of InGaN above the second conductivity type cladding layer (24);
forming a first conductivity type cladding layer (22) made of GaN of the first conductivity type above the active layer (23); and
forming a lower cladding layer (21) made of GaN of the first conductivity type above the first conductivity type cladding layer (22), and
the removing the support substrate (33) is performed by laser lift-off.

18. The method according to any of claims 14-17, wherein the doping with the second conductivity type impurity includes:
forming a barrier film (31) above the semiconductor substrate (11);
forming an opening (32) in the barrier film (31);
exposing the semiconductor substrate (11) to an atmosphere containing the second conductivity type impurity; and
performing heat treatment to make the second conductivity type impurity adsorbed on the semiconductor substrate (11) be diffused into the semiconductor substrate (11) and be activated.
